# EUROPÄISCHE PATENTSCHRIFT

(11) **EP 0 554 552 B1**
(45) Veröffentlichungstag und Bekanntmachung des Hinweises auf die Patenterteilung: **11.10.1995**
(21) Anmeldenummer: 92121375.7
(22) Anmeldetag: 16.12.1992
(51) Int. Cl.: H01J 37/32, C23C 14/32

(54) **Verfahren und Vorrichtung zur Materialverdampfung in einem Vakuumbehälter**
Process and device for evaporating materials in a vacuum vessel
Procédé et dispositif pour l'évaporation de matériaux dans une enceinte à vide

(30) Priorität: 06.02.1992 DE 4203371
(43) Veröffentlichungstag der Anmeldung: 11.08.1993
(73) Patentinhaber: METAPLAS Oberflächenveredelungstechnik GmbH, D-51427 Bergisch Gladbach (DE)
(72) Erfinder: Vetter, Jörg, Dr., W-5060 Bergisch-ladbach 2 (DE); Schmidt-Mauer, Manfred, W-5036 Overath (DE)
(74) Vertreter: Stenger, Watzke & Ring Patentanwälte

(56) Entgegenhaltungen:
- WO-A-92/03841
- DE-A- 3 829 260
- US-A- 4 620 913

## Beschreibung

Die Erfindung betrifft ein Verfahren und eine Vorrichtung zur Materialverdampfung in einem Vakuumbehälter durch Beschuß des zu verdampfenden Materials mit Elektronen aus einer Vakuum-Bogen-Verdampfung, insbesondere zur Oberflächenbeschichtung von Substraten, mit einer Abschirmung der selbstverzehrenden Kathode und einer Stromquelle zur Erzeugung der Bogenspannung zwischen der selbstverzehrenden Kathode und einer Anode.

Die Lebensdauer von Maschinenteilen und die Einsatzzeit von Werkzeugen wird durch den bei ihrem Einsatz auftretenden Verschleiß begrenzt. Wegen der ständig zunehmenden Automatisierung und Verkettung von Produktionsprozessen ist ein durch Verschleiß einzelner Teile ausgelöster Maschinenstillstand ein erheblicher Kostenfaktor, so daß einem Verschleißschutz eine zunehmende wirtschaftliche Bedeutung zukommt.

Zur erheblichen Reduzierung des Verschleisses von Maschinenteilen und Werkzeugen haben sich seit Jahren Beschichtungen mit dünnen Hartstoffschichten bewährt, wobei die in der Praxis eingesetzten Hartstoffe, wie beispielsweise Nitride und Carbide sehr harte, gut leitende und extrem verschleißbeständige Werkstoffe ergeben. Da ihrem Einsatz als Vollmaterial neben dem hohen Preis ihre Sprödigkeit und Bruchanfälligkeit entgegensteht, werden derartige Hartstoffe als dünne Schichten auf Bauteile aus Stahl und anderen Werkstoffen aufgebracht. Durch diese Beschichtung verlieren die Hartstoffe ihre Sprödigkeit und passen sich weitgehend der Zähigkeit des Grundwerkstoffes an. Unter Aufrechterhaltung der Zähigkeit des Bauteils ergeben sich somit durch die Beschichtung mit Hartstoffen extrem harte Oberflächen. Durch Verwendung von Schichtdicken von weniger als 100 Mikrometer bleibt die Maßhaltigkeit der beschichteten Teile erhalten, so daß Nacharbeit nur in Ausnahmefällen erforderlich ist. Außerdem haben derartige Hartstoffschichten geringe Reibbeiwerte und gute Gleiteigenschaften.

Um derartige dünne Hartstoffschichten zu erzeugen, bedarf es der Aufdampfung der Schichten in einem Vakuumverfahren, wobei die eigentlichen Hartstoffe erst während der Beschichtung aus Metallanteilen und Gasen, wie beispielsweise Stickstoff entstehen. Neben der chemischen Abscheidung aus der Dampfphase, die zum Zustandekommen der chemischen Reaktionen hohe Bauteiltemperaturen im Bereich zwischen 800° und 1100° C benötigt, wird die physikalische Abscheidung aus der Dampfphase angewandt, bei der Metalldampf direkt erzeugt wird und auf dem Bauteil mit dem Gas zum Hartstoff reagiert. Dieses sogenannte PVD-Verfahren (Physical Vapour Deposition) findet bei Temperaturen zwischen 200° und 650° C statt und ermöglicht demzufolge Beschichtungen auf bereits vergüteten Stählen ohne Härteverlust und Verzug und im Gegensatz zur chemischen Abscheidung aus der Dampfphase ohne Umweltbelastung. Außerdem ist das PVD-Verfahren geeignet, Metallschichten auf verschiedensten Substraten für die unterschiedlichsten funktionellen Anforderungen abzuscheiden. Beispielsweise können dekorative oder elektrisch und magnetisch aktive Metallschichten auf Bauteilen aus Glas, Keramik und Kunststoff abgeschieden werden. Derartige Schichten können auch als korrisionsmindernde Schichten auf metallischen Bauteilen dienen.

Das bekannte Verfahren benutzt zur physikalischen Materialverdampfung einen Vakuumbehälter, in dem das zu verdampfende Material mit Elektronen aus einer Vakuum-Bogen-Verdampfung beschossen wird. Zur Erzeugung der Bogenspannung ist eine Stromquelle vorgesehen, deren negativer Pol mit einer selbstverzehrenden Kathode und deren positiver Pol mit einer selbstverzehrenden Anode verbunden ist, wobei die selbstverzehrende Kathode mit einer Abschirmung versehen ist. Durch den Vakuum-Bogen werden Elektronen erzeugt, wobei sich die Kathode zwangsläufig verzehrt. Damit dieses Kathodenmaterial nicht auf die Substrate gelangt, ist die Kathode abgeschirmt. Die erzeugten Elektronen rufen durch ihr Auftreffen auf die Anode eine Verdampfung des Anodenmaterials hervor, so daß sich auch die Anode verzehrt. Dieses verdampfte Anodenmaterial lagert sich als Beschichtung auf den Substraten ab.

Ein Verfahren der voranstehend beschriebenen Art mit einer anodischen Vakuum-Bogen-Verdampfung ist aus der DE-PS 34 13 891 bekannt. Bei diesem Verfahren wird zwischen einer mehr oder weniger abgedeckten, kalten selbstverzehrenden Kathode und einer heißen selbstverzehrenden Anode eine Vakuum-Bogen-Entladung aufrechterhalten, wobei aus der heißen selbstverzehrenden Anode der zur Beschichtung genutzte Metalldampf austritt. Die zur Anode fliegenden Elektronen des Vakuum-Bogen-Plasmas ionisieren dabei das von der Anode abdampfende Material durch inelastische Stöße.

Dieses bekannte Verfahren hat den Nachteil, daß eine bestimmte räumliche Zuordnung von Kathode und Anode gegeben sein muß und daß der Beschichtungsprozeß nur begrenzt regelbar ist, weil dieser sowohl die Erzeugung von Elektronen in der Vakuum-Bogen-Verdampfung als auch die Verwendung dieser Elektronen zur Verdampfung des Beschichtungsmaterials umfaßt. Eine unabhängige Beeinflussung der Elektronenerzeugung einerseits und des Beschusses des Beschichtungsmaterials durch die erzeugten Elektronen andererseits ist nicht möglich.

Um hier eine gewisse Abhilfe zu schaffen, wird mit der DE-PS 40 42 337 ein Verfahren vorgeschlagen, bei dem der Ionisationsgrad dadurch gesteuert wird, daß der geradlinige Stromfluß zwischen der Arbeitsfläche der Kathode und dem Verdampfungsgut an der Anode mittels einer beweglichen Abschirmung behindert wird, wobei der Grad dieser Behinderung den Ionisationsgrad des Dampfes steuert. Eine solche Behinderung hat nur eine begrenzte Wirkung und schafft keine unabhängige Beeinflussung von Elektronenerzeugung und Verdampfung des Beschichtungsmaterials.

Der Erfindung liegt die **Aufgabe** zugrunde, das bekannte Verfahren der voranstehend beschriebenen Art derart weiterzubilden, daß eine stufenlose Regelung einerseits der Elektronenerzeugung und andererseits der Verdampfung und schließlich des Ionisierungsgrades bei weitgehend unabhängiger räumlicher Anordnung der selbstverzehrenden Kathode und der selbstverzehrenden Anode möglich ist.

Die **Lösung** dieser Aufgabenstellung durch die Erfindung ist dadurch gekennzeichnet, daß durch eine zweite, steuerbare Stromquelle zwischen der Anode der kathodischen Vakuum-Bogen-Verdampfung und einer zweiten selbstverzehrenden Anode die durch die kathodische Vakuum-Bogen-Verdampfung erzeugten Elektronen unter Zufuhr eines Gases oder Gasgemisches in den Vakuumbehälter gezielt der selbstverzehrenden Anode zugeführt werden.

Durch die erfindungsgemäße Weiterbildung des bekannten Verfahrens wird es möglich, die Elektronenerzeugung aufgrund der Vakuum-Bogen-Verdampfung durch Veränderung des Bogenstroms aus der ersten Stromquelle stufenlos zu regeln und unabhängig davon den Elektronenfluß zur heißen, selbstverzehrenden Anode durch Spannungsänderung der zweiten Stromquelle stufenlos zu regeln, wobei gleichzeitig der Ionisierungsgrad durch Wahl der Art des Gases oder Gasgemisches und des Gasdruckes steuerbar ist. Die insbesondere zur Oberflächenbeschichtung von Substraten verwendete Materialverdampfung im Vakuumbehälter läßt sich somit hinsichtlich ihrer Parameter unabhängig voneinander gezielt dem jeweiligen Anwendungsfall anpassen, ohne daß eine bestimmte räumliche Zuordnung der Kathode, der Anoden und der Substrate erforderlich ist.

Gemäß einem weiteren Merkmal der Erfindung kann beim erfindungsgemäßen Verfahren zur Konditionierung der Substrate die Leistung der zweiten Stromquelle derart eingestellt werden, daß unter Vermeidung einer Verdampfung des Materials der selbstverzehrenden Anode die Gasatome des Gases oder Gasgemisches ionisiert werden. Hierdurch ist es möglich, vor der eigentlichen Beschichtung der Substrate diese durch Beschuß mit Ionen zu reinigen und zu erwärmen.

Bei einer erfindungsgemäßen Weiterbildung können die durch mindestens eine kathodische Vakuum-Bogen-Verdampfung erzeugten Elektronen zur gleichzeitigen oder aufeinander folgenden Verdampfung mehrerer selbstverzehrender Anoden genutzt werden, so daß die Abscheidung von mehrlagigen Schichten oder von mehrkomponentigen Schichten möglich ist, wenn selbstverzehrende Anoden aus unterschiedlichen Materialien eingesetzt werden.

Die erfindungsgemäße Vorrichtung zur Durchführung des voranstehend beschriebenen Verfahrens ist dadurch gekennzeichnet, daß zusätzlich zu einer eine kathodische Vakuum-Bogen-Verdampfung bewirkenden Stromquelle eine zweite regelbare Stromquelle zwischen der nicht selbstverzehrenden Anode der kathodischen Vakuum-Bogen-Verdampfung und einer selbstverzehrenden zweiten Anode zur Regelung des Elektronenflusses für die Verdampfung vorgesehen ist. Die beiden unabhängig voneinander wirksamen Stromquellen gestatten eine stufenlose Regelung einerseits der Elektronenerzeugung und andererseits der Verdampfung, wobei zusätzlich der Vorteil entsteht, daß eine fast beliebige Anordnung der beteiligten Elemente innerhalb des Vakuumbehälters möglich ist.

Um auf besonders einfache Weise vor dem eigentlichen Beschichtungsvorgang eine Konditionierung der bereits im Vakuumbehälter befindlichen Substrate, insbesondere eine Reinigung ihrer Oberfläche und eine Erwärmung zu erzielen, kann gemäß einem weiteren Merkmal der erfindungsgemäßen Vorrichtung eine zusätzliche, sich nicht verzehrende Anode als Alternative zu der sich verzehrenden Anode im Vakuumbehälter angeordnet sein. Wenn anstelle der sich selbstverzehrenden Anode diese kalte Anode mit der zweiten Stromquelle verbunden wird, läßt sich der Ionisierungsgrad und der Zustand des Plasmas derart einstellen, daß die auf die Substrate auftreffenden Elektronen ohne Verdampfung der selbstverzehrenden Anode eine Konditionierung der Substrate bewirken. Zur Durchführung des eigentlichen Beschichtungsvorganges wird anschließend anstelle der kalten Anode die selbstverzehrende Anode mit der zweiten Stromquelle verbunden.

Um den auf die selbstverzehrende Anode einwirkenden Elektronenfluß aus der von der ersten Stromquelle bewirkten kathodischen Vakuum-Bogen-Verdampfung beeinflussen zu können, kann gemäß einem weiteren Merkmal der Erfindung die Abschirmung der Kathode zur Freigabe der aktiven Fläche der Kathode beweglich angeordnet sein.

Die Variationsmöglichkeiten des Beschichtungsvorganges können erfindungsgemäß dadurch erweitert werden, daß außer mindestens einer selbstverzehrenden Anode mit eigener, einzeln regelbarer Stromquelle mehrere Kathoden mit zugehöriger Abschirmung zur Erhöhung und Vergleichmäßigung der Verdampfungsleistung angeordnet sind.

Um die Beschleunigung des Ionenflusses auf die Substrate regeln zu können, kann erfindungsgemäß ein Substrathalter verwendet werden, der durch eine dritte regelbare Stromquelle auf einem negativen Potential gehalten wird.

Bei einer bevorzugten Ausführungsform der Erfindung ist der Vakuumbehälter als nicht selbstverzehrende Anode der kathodischen Vakuum-Bogen-Verdampfung ausgebildet. Hierdurch ergibt sich eine besonders einfache Konstruktion.

Der Totaldruck des Gases oder des Gasgemisches im Vakuumbehälter liegt erfindungsgemäß im Bereich von 1 X 10⁻⁴ bis 2 X 10⁻² mbar. Die Anodenspannungen liegen zwischen 10 und 50 V, die Anodenströme zwischen 20 und 300 A. Die Substratstromdichten liegen zwischen 0,2 und 2 m A cm⁻².

Auf der Zeichnung sind drei Ausführungsbeispiele der erfindungsgemäßen Vorrichtung schematisch dargestellt, und zwar zeigen:
- Fig. 1: eine erste Ausführungsform der erfindungsgemäßen Vorrichtung mit einer selbstverzehrende; Anode und einer kalten Anode, die alternativ mit der zweiten Stromquelle verbunden werden können,
- Fig. 2: eine zweite Ausführungsform mit zwei alternativ betreibbaren selbstverzehrenden Anoden und
- Fig. 3: eine dritte Ausführungsform mit zwei entweder gleichzeitig oder nacheinander betreibbaren selbstverzehrenden Anoden, denen jeweils eine eigene kathodische Vakuum-Bogen-Verdampfung zugeordnet ist.

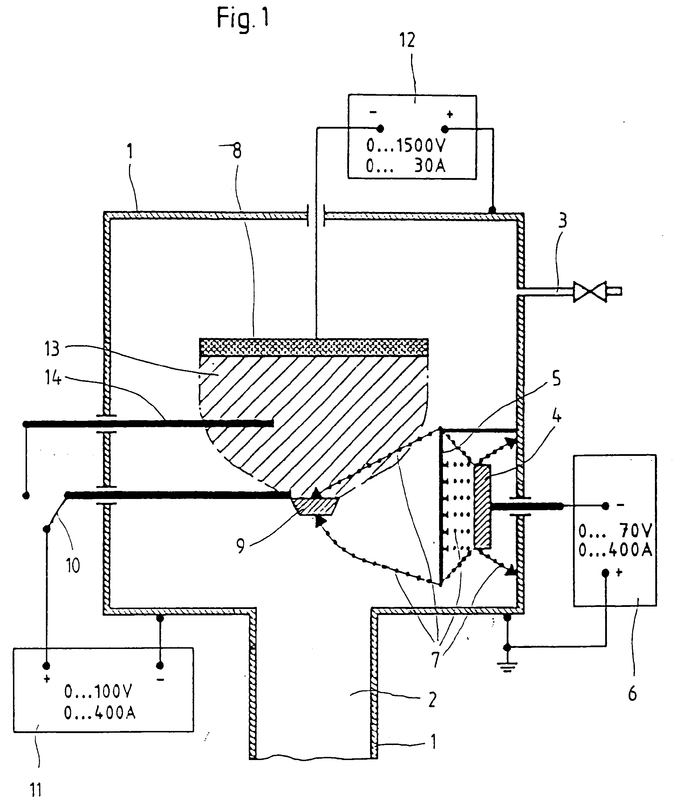

Das in Fig. 1 schematisch dargestellte erste Ausführungsbeispiel zeigt einen Vakuumbehälter 1, der mit einer verschließbaren Beschickungsöffnung 2 und einer Anschlußleitung 3 versehen ist, durch welche dem Vakuumbehälter 1 ein Gas oder Gasgemisch, wie beispielsweise Argon, Stickstoff oder ein kohlenwasserstoffhaltiges Gasgemisch zugeführt werden kann.

In der einen Ecke des Vakuumbehälters 1 befindet sich eine selbstverzehrende Kathode 4, die gegenüber dem Inneren des Vakuumbehälters 1 durch ein als Anode ausgebildetes Abschirmblech 5 abgeschirmt ist. Durch eine mit ihrem Minuspol an die Kathode 4 und mit ihrem Pulspol an den Vakuumbehälter 1 und damit das Abschirmblech 5 angeschlossene erste Stromquelle 6 wird zwischen der Kathode 4 und dem als Anode wirkenden Abschirmblech 5 eine kathodische Vakuum-Bogen-Verdampfung erzielt, die der Erzeugung von Elektronen dient. Der Elektronenfluß zwischen dem als Anode wirkenden Abschirmblech 5 und der selbstverzehrenden Kathode 4 ist in Fig. 1 durch Punkte eingezeichnet. Die Zeichnung läßt weiterhin erkennen, daß ein bestimmter Elektronenfluß seitlich neben dem Abschirmblech 5 austritt. Dieser Elektronenfluß ist durch gepunktete Linien dargestellt und mit der Bezugsziffer 7 gekennzeichnet.

Von der selbstverzehrenden Kathode 4 durch das Abschirmblech 5 abgedeckt ist in dem Vakuumbehälter 1 ein Substrathalter 8 angeordnet, auf dem die zu beschichtenden Gegenstände (Substrate) angeordnet werden. Um die Oberfläche dieser Substrate zu beschichten, ist in dem Vakuumbehälter 1 eine selbstverzehrende Anode 9 angeordnet, die beim Ausführungsbeispiel die Form eines Verdampfertiegels hat und das Beschichtungsmaterial enthält. Diese selbstverzehrende Anode 9 ist über einen Schalter 10 mit dem Pluspol einer zweiten Stromquelle 11 verbindbar, deren Minuspol mit dem Vakuumbehälter 1 verbunden ist. Auf diese Weise ist es möglich, durch Einstellen einer bestimmten Spannung an der selbstverzehrenden Anode 9 im Verhältnis zu der Spannung zwischen der Kathode 4 und dem als Anode dienenden Abschirmblech 5 einen jeweils gewünschten Teil des Elektronenflusses 7 auf das im Verdampfertiegel der selbstverzehrenden Anode 9 befindliche Material zu lenken. Die auf das Material auftreffenden Elektronen führen zu einer Verdampfung dieses Beschichtungsmaterials, so daß sich dieses auf der Oberfläche der am Substrathalter 8 angeordneten Substrate ablagert. Um die Ablagerung des verdampften Beschichtungsmaterials auf den Substraten zu steuern, wird beim Ausführungsbeispiel am Substrathalter 8 ein negatives Potential erzeugt. Hierzu dient eine dritte Stromquelle 12, deren Minuspol mit dem Substrathalter 8 und deren Pluspol mit dem Vakuumbehälter 1 verbunden ist.

In Fig. 1 ist schraffiert der Transportraum 13 angedeutet, der bevorzugt mit dem verdampften Material der selbstverzehrenden Anode 9 gefüllt ist. Der Ionisationsgrad in diesem Transportraum 13 läßt sich durch die Anwesenheit eines Inertgases beliebig regeln, wobei das Inertgas durch inelastische Stöße mit den beschleunigten Elektronen aus der kathodischen Vakuum-Bogen-Verdampfung hochgradig ionisiert werden kann.

Durch die plasmagestützte Abscheidung des Beschichtungsmaterials aus der Dampfphase werden hochenergetische Teilchen bereitgestellt, die an der Schichtbildung teilhaben und bei niedriger Beschichtungstemperatur eine große Haftfestigkeit der Oberflächenbeschichtung und sehr gute Schichtmorphologien ergeben. Durch das Vorhandensein eines ionisierten Reaktivgases kann darüber hinaus eine hohe chemische Reaktivität geschaffen werden, so daß auch reaktive Schichtbildungen bei niedrigen Temperaturen möglich sind. Schließlich besteht die Möglichkeit, mittels der erzeugten Plasmen diamantähnliche Schichten oder gar Diamantschichten aufzubringen.

Da neben der ersten Stromquelle 6 zur Erzeugung der kathodischen Vakuum-Bogen-Verdampfung zwischen Kathode 4 und Abschirmblech 5 eine zweite, unabhängig von der ersten regelbare Stromquelle 11 vorhanden ist, läßt sich die Elektronenstrahl-Verdampfung der heißen selbstverzehrenden Anode 9 in Anwesenheit eines Inertgases beliebig steuern. Die Regelparameter einerseits der Elektronenerzeugung und andererseits der Verdampfung des Beschichtungsmaterials erfahren hierdurch eine erhebliche Erweiterung.

Neben der einfachen Steuerung der Verdampfungsrate und des Ionisationsgrades ergibt die Verwendung der zweiten Stromquelle 11 den Vorteil, daß die Einbaulage und die Form der heißen selbstverzehrenden Anode 9 die Entladung nur unwesentlich beeinflussen, so daß in jedem Fall die Leistung an der heißen selbstverzehrenden Anode 9 kontinuierlich von Null bis auf einen Maximalwert regelbar ist.

Bei der Ausführungsform nach Fig. 1 ragt in den Transportraum 13 eine kalte Anode 14 hinein, die mittels des Schalters 10 anstelle der heißen selbstverzehrenden Anode 9 mit dem Pluspol der zweiten Stromquelle 11 verbunden werden kann. Mit Hilfe dieser kalten Anode 14 kann eine negative Substratvorspannung bzw. das Entstehen eines negativen Potentials an den Substraten erzeugt werden, so daß das in dem Vakuumbehälter 1 entstehende Plasma vor dem eigentlichen Beschichtungsvorgang zum Aufheizen oder Ionenreinigen der Substrate eingesetzt werden kann. Weiterhin ist es möglich, durch das Ausbilden eines negativen Potentials an den Substraten ein Ionenbombardement während der Schichtbildung auszuführen.

Die Betriebsgrößen der drei Stromquellen 6,11 und 12 sind in Fig. 1 eingezeichnet. Sie lassen erkennen, daß die erste Stromquelle 6 mit einer Spannung zwischen 0 und 70 V und einem Strom zwischen 0 und 400 A betrieben werden kann. Der Spannungsbereich der zweiten Stromquelle 11 liegt zwischen 0 und 100 V und der Strombereich zwischen 0 und 400 A. Die dritte Stromquelle 12 kann zwischen 0 und 1500 V und zwischen 0 und 30 A betrieben werden. Die in dem Vakuumbehälter 1 herrschenden Totaldrücke des Gases oder Gasgemisches liegen im Bereich von 1 X 10⁻⁴ bis 2 X 10⁻² mbar. Die entstehenden Substratstromdichten liegen zwischen 0,1 bis 2 m A cm⁻². Um Metall-Kohlenstoff-Schichten abzuscheiden, kann auch ein kohlenwasserstoffhaltiges Gas oder Gasgemisch in den Vakuumbehälter 1 eingelassen werden. Schließlich ist es möglich, als Gas bzw. Gasgemisch ein Reaktivgas in den Vakuumbehälter 1 einzuführen, um Hartstoffschichten auf den Substraten abzuscheiden.

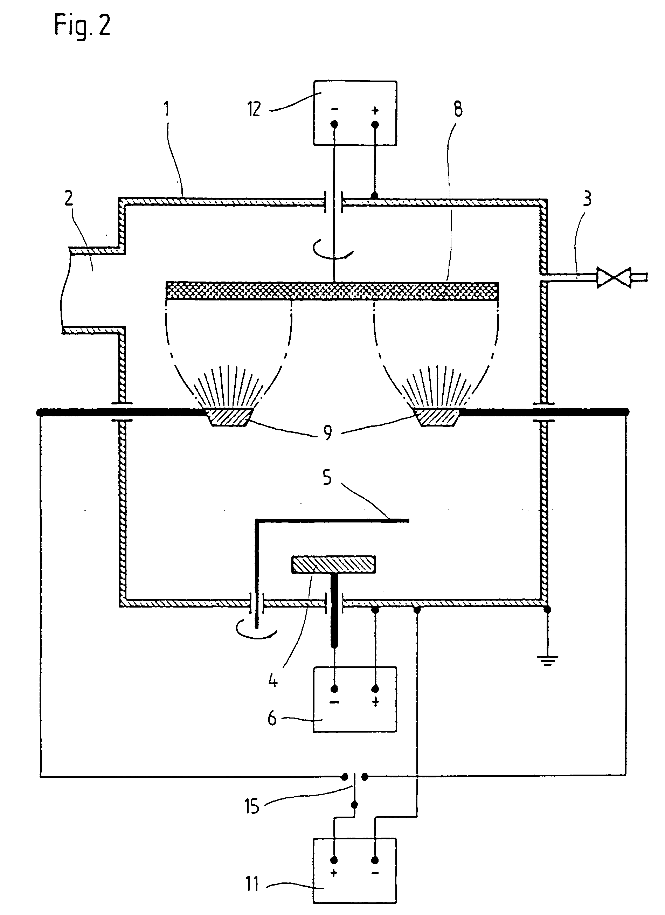

Das zweite Ausführungsbeispiel nach Fig. 2 zeigt wiederum einen Vakuumbehälter 1 mit einem in diesem Fall drehbaren Substrathalter 8. Auch bei dieser zweiten Ausführungsform wird mittels einer dritten Stromquelle 12 ein negatives Potential an den Substraten erzeugt und durch die Anschlußleitung 3 ein Gas oder Gasgemisch in den Vakuumbehälter 1 eingeführt.

Die kathodische Vakuum-Bogen-Verdampfung wird ebenfalls zwischen einer selbstverzehrenden Kathode 4 und einer kalten Anode erzeugt, die als Abschirmblech 5 ausgebildet ist. Dieses Abschirmblech 5 ist bei der zweiten Ausführungsform nach Fig. 2 beweglich angeordnet, so daß die aktive Fläche der Kathode 4 variiert werden kann. Neben der ersten Stromquelle 6 ist wiederum eine zweite Stromquelle 11 vorgesehen, deren Minuspol mit dem Vakuumbehälter 1 verbunden ist. Der Pluspol der zweiten Stromquelle 11 kann über einen Schalter 15 wahlweise mit einer von zwei heißen selbstverzehrenden Anoden 9 verbunden werden. Hierdurch ist es möglich, die beiden heißen selbstverzehrenden Anoden 9 wechselseitig zu betreiben, um Mehrlagenschichten herzustellen. Neben dem wechselseitigen Betreiben der heißen selbstverzehrenden Anoden 9 kann auch das Abschirmblech 5 zwischen der kalten selbstverzehrenden Kathode 4 und den Substraten entfernt werden, so daß das Material der kalten selbstverzehrenden Kathode 4 an der Schichtbildung teilhaben kann oder das Plasma zur Substratkonditionierung (Erwärmen und Ionenreinigung der Substrate) genutzt werden kann.

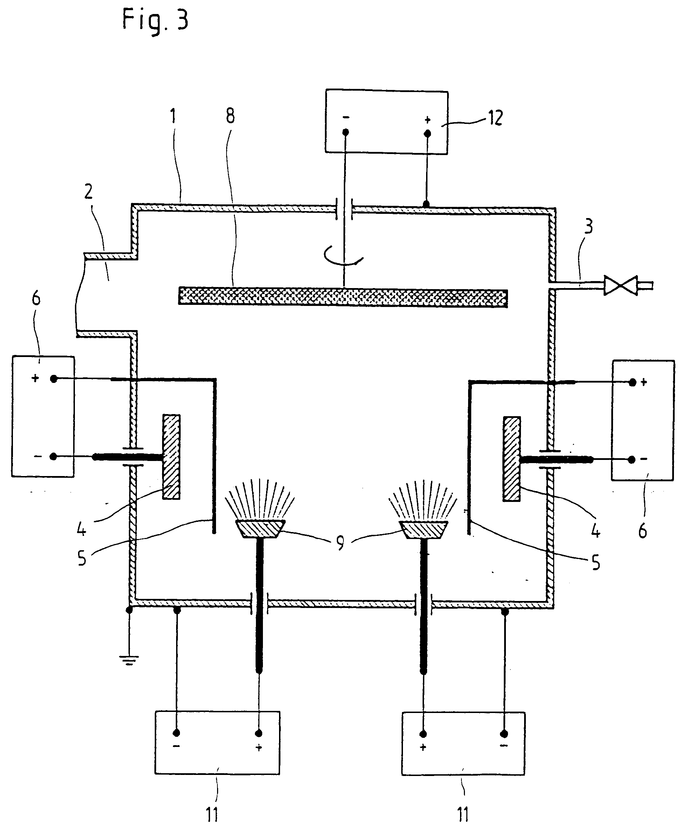

Die Fig. 3 zeigt schließlich den schematischen Aufbau einer Ausführungsform mit zwei Einrichtungen zur kathodischen Vakuum-Bogen-Verdampfung. Beim Ausführungsbeispiel sind in den Vakuumbehälter 1 einander gegenüberliegend zwei selbstverzehrende Kathoden 4 und als nicht selbstverzehrende Anoden dienende Abschirmbleche 5 angeordnet, die jeweils mit Hilfe einer eigenen ersten Stromquelle 6 zur Erzeugung einer kathodischen Vakuum-Bogen-Verdampfung eingesetzt werden. Weiterhin sind zwei selbstverzehrende Anoden 9 vorgesehen, die jeweils mit dem Pluspol einer eigenen Stromquelle 11 verbunden sind.

Hierdurch ist es möglich, entweder Mehrlagenschichten oder mehrkomponentige Schichten abzuscheiden, wobei der Anteil des jeweils eine selbstverzehrende Anode 9 bildenden Materials beliebig zwischen einem und 99 % eingestellt werden kann. Durch Verwenden eines Reaktivgases, beispielsweise Stickstoff, können Hartstoffschichten, beispielsweise TiN abgeschieden werden. Auch das Abscheiden von harten Kohlenwasserstoffschichten, die keinen oder einen bestimmten metallanteil aufweisen, ist dadurch möglich, daß ein kohlenwasserstoffhaltiges Gas in den Vakuumbehälter 1 zugegeben wird.

Bei allen Ausführungsbeispielen können durch die Leistung der zweiten Stromquelle 11 die Verdampfungsrate und der Ionisationsgrad des auf das Substrat auftreffenden Teilchenstroms geregelt werden. Hierbei ist es möglich, die Leistung der zweiten Stromquellen 11 derart niedrig zu wählen, daß im wesentlichen die Gasatome des Gases oder Gasgemisches ionisiert werden, ohne daß es zu einer Verdampfung des Anodenmaterials kommt. Hierdurch ist insbesondere eine Erwärmung und Reinigung der Substrate möglich. Durch das Anlegen einer negativen Vorspannung an den Substraten mittels der dritten Stromquelle 12 kann die Auftreffgeschwindigkeit der Gasionen auf die Substrate erhöht werden, um die Ionenreinigung und Erwärmung der Substrate zu verbessern.

### Bezugszeichenliste:

- 1: Vakuumbehälter
- 2: Beschickungsöffnung
- 3: Anschlußleitung
- 4: Kathode
- 5: Abschirmblech
- 6: erste Stromquelle
- 7: Elektronenfluß
- 8: Substrathalter
- 9: Anode
- 10: Schalter
- 11: zweite Stromquelle
- 12: dritte Stromquelle
- 13: Transportraum
- 14: Anode
- 15: Schalter

## Patentansprüche

1. Verfahren zur Materialverdampfung in einem Vakuumbehälter durch Beschuß des zu verdampfenden Materials mit Elektronen aus einer Vakuum-Bogen-Verdampfung, insbesondere zur Oberflächenbeschichtung von Substraten, mit einer Abschirmung der selbstverzehrenden Kathode und einer Stromquelle zur Erzeugung der Bogenspannung zwischen der selbstverzehrenden Kathode und einer Anode,
**dadurch gekennzeichnet**,
daß durch eine zweite, steuerbare Stromquelle zwischen der Anode der kathodischen Vakuum-Bogen-Verdampfung und einer zweiten selbstverzehrenden Anode die durch die kathodische Vakuum-Bogen-Verdampfung erzeugten Elektronen unter Zufuhr eines Gases oder Gasgemisches in den Vakuumbehälter gezielt der selbstverzehrenden Anode zugeführt werden.

2. Verfahren nach Anspruch 1, dadurch gekennzeichnet, daß zur Konditionierung der Substrate die Leistung der zweiten Stromquelle derart eingestellt wird, daß unter Vermeidung einer Verdampfung des Materials der selbstverzehrenden Anode die Gasatome des Gases oder Gasgemisches ionisiert werden.

3. Verfahren nach Anspruch 1, dadurch gekennzeichnet, daß die durch mindestens eine kathodische Vakuum-Bogen-Verdampfung erzeugten Elektronen zur gleichzeitigen oder aufeinanderfolgenden Verdampfung mehrerer selbstverzehrender Anoden genutzt werden.

4. Vorrichtung zur Durchführung des Verfahrens nach mindestens einem der Ansprüche 1 bis 3, dadurch gekennzeichnet, daß zusätzlich zu einer eine kathodische Vakuum-Bogen-Verdampfung bewirkenden Stromquelle (6) eine zweite regelbare Stromquelle (11) zwischen der nicht selbstverzehrenden Anode der kathodischen Vakuum-Bogen-Verdampfung und einer selbstverzehrenden zweiten Anode (9) zur Regelung des Elektronenflusses für die Verdampfung vorgesehen ist.

5. Vorrichtung nach Anspruch 4, dadurch gekennzeichnet, daß eine zusätzliche, sich nicht verzehrende Anode (14) als Alternative zu der sich verzehrenden Anode (9) im Vakuumbehälter (1) angeordnet ist.

6. Vorrichtung nach Anspruch 4 oder 5, dadurch gekennzeichnet, daß die Abschirmung (5) der Kathode (4) zur Freigabe der aktiven Fläche der Kathode (4) beweglich angeordnet ist.

7. Vorrichtung nach mindestens einem der Ansprüche 4 bis 6, dadurch gekennzeichnet, daß außer mindestens einer selbstverzehrenden Anode (9) mit eigener, einzeln regelbarer Stromquelle (11) mehrere Kathoden (4) mit zugehöriger Abschirmung (5) zur Erhöhung und Vergleichmäßigung der Verdampfungsleistung angeordnet sind.

8. Vorrichtung nach mindestens einem der Ansprüche 4 bis 7, gekennzeichnet durch einen Substrathalter (8), der durch eine dritte regelbare Stromquelle (12) auf einem negativen Potential gehalten wird.

9. Vorrichtung nach mindestens einem der Ansprüche 4 bis 8, dadurch gekennzeichnet, daß der Vakuumbehälter (1) als nicht selbstverzehrende Anode der kathodischen Vakuum-Bogen-Verdampfung ausgebildet ist.

10. Vorrichtung nach mindestens einem der Ansprüche 4 bis 9, dadurch gekennzeichnet, daß der Totaldruck des Gases bzw. Gasgemisches im Vakuumbehälter (1) im Bereich von 1 X 10⁻⁴ bis 2 X 10⁻² mbar beträgt.

## Claims

1. Method for material vaporization in a vacuum container by firing electrons from a vacuum arc vaporization at the material to be vaporized, in particular for surface coating of substrates, having a screen for the sacrificial cathode and an electrical power source for producing the arc voltage between the sacrificial cathode and an anode, characterized in that the electrons which are produced by the cathodic vacuum arc vaporization are deliberately fed to the sacrificial anode, with a gas or gas mixture being fed into the vacuum container, by means of a second, controllable electrical power source between the anode of the cathodic vacuum arc vaporization and a second sacrificial anode.

2. Method according to Claim 1, characterized in that the power of the second electrical power source is adjusted, in order to condition the substrates, in such a manner that the gas atoms of the gas or gas mixture are ionized while avoiding the material of the sacrificial anode being vaporized.

3. Method according to Claim 1, characterized in that the electrons which are produced by at least one cathodic vacuum arc vaporization are used for the simultaneous or successive vaporization of a plurality of sacrificial anodes.

4. Device for carrying out the method according to at least one of Claims 1 to 3, characterized in that, in addition to an electrical power source (6) which produces cathodic vacuum arc vaporization, a second electrical power source (11) which can be regulated is provided between the non-sacrificial anode of the cathodic vacuum arc vaporization and a sacrificial second anode (9), in order to regulate the electron flux for the vaporization.

5. Device according to Claim 4, characterized in that an additional, non-sacrificial anode (14) is arranged in the vacuum container (1), as an alternative to the sacrificial anode (9).

6. Device according to Claim 4 or 5, characterized in that the screen (5) of the cathode (4) is arranged in a moving manner in order to release the active surface of the cathode (4).

7. Device according to at least one of Claims 4 to 6, characterized in that, in addition to at least one sacrificial anode (9) having its own electrical power source (1) which can be regulated individually, a plurality of cathodes (4) are arranged having an associated screen (5) in order to enhance and homogenize the vaporization performance.

8. Device according to at least one of Claims 4 to 7, characterized by a substrate holder (8) which is kept at a negative potential by a third electrical power source (12) which can be regulated.

9. Device according to at least one of Claims 4 to 8, characterized in that the vacuum container (1) is designed as a non-sacrificial anode of the cathodic vacuum arc vaporization.

10. Device according to at least one of Claims 4 to 9, characterized in that the total pressure of the gas or gas mixture in the vacuum container (1) is in the range from 1 X 10⁻⁴ to 2 X 10⁻² mbar.

## Revendications

1. Procédé d'évaporation de matériau dans une enceinte à vide, par bombardement du matériau à évaporer par des électrons venant d'une évaporation à l'arc sous vide, notamment pour le revêtement de surface de substrats, avec un blindage de la cathode autoconsommable et une source de courant pour la production de la tension d'arc entre la cathode autoconsommable et une anode,
caractérisé en ce que
les électrons produits par l'évaporation cathodique à l'arc sous vide, par une deuxième source de courant réglable, entre l'anode de l'évaporation cathodique à l'arc sous vide et une deuxième anode autoconsommable, sont acheminés, avec apport d'un gaz ou d'un mélange de gaz, dans l'enceinte à vide de manière appropriée vers l'anode autoconsommable.

2. Procédé selon la revendication 1, caractérisé en ce que, pour le conditionnement des substrats, la puissance de la deuxième source de courant est réglée de telle manière que les atomes de gaz du gaz ou du mélange gazeux soient ionisés en évitant une évaporation du matériau de l'anode autoconsommable.

3. Procédé selon la revendication 1, caractérisé en ce que les électrons produits par au moins une évaporation cathodique à l'arc sous vide sont utilisés pour une évaporation simultanée ou suivante de plusieurs anodes autoconsommables.

4. Dispositif pour la mise en oeuvre du procédé selon au moins l'une des revendications 1 à 3, caractérisé en ce qu'il est prévu en plus d'une source de courant (6) pour effectuer l'évaporation cathodique à l'air sous vide, une deuxième source de courant (11) réglable, entre l'anode non autoconsommable de l'évaporation cathodique à l'arc sous vide et une deuxième anode autoconsommable (9), pour le réglage du flux électronique pour l'évaporation.

5. Dispositif selon la revendication 4, caractérisé en ce qu'une anode supplémentaire (14) non autoconsommable est disposée, à la place de l'anode autoconsommable (9), dans l'enceinte à vide (1).

6. Dispositif selon la revendication 4 ou 5, caractérisé en ce que le blindage (5) de la cathode (4) est disposé mobile afin de libérer la surface active de la cathode (4).

7. Dispositif selon au moins l'une des revendications 4 à 6, caractérisé en ce que, outre au moins une anode autoconsommable (9) ayant sa propre source de courant (11) réglable indépendamment, il est prévu plusieurs cathodes (4) avec un blindage (5) associé pour augmenter et homogénéiser la puissance d'évaporation.

8. Dispositif selon au moins l'une des revendications 4 à 7, caractérisé par un porte-substrat (8), qui est maintenu au moyen d'une troisième source de courant réglable (12) à un potentiel négatif.

9. Dispositif selon au moins l'une des revendications 4 à 8, caractérisé en ce que l'enceinte à vide (1) est conçue en tant qu'anode non autoconsommable de l'évaporation cathodique à l'arc sous vide.

10. Dispositif selon au moins l'une des revendications 4 à 9, caractérisé en ce que la pression totale du gaz ou du mélange de gaz dans l'enceinte à vide (1) se situe entre 1 X 10⁻⁴ et 2 X 10⁻² mbsars.
